# EUROPÄISCHE PATENTSCHRIFT

(11) **EP 3 684 578 B1**
(45) Veröffentlichungstag und Bekanntmachung des Hinweises auf die Patenterteilung: **11.01.2023**
(21) Anmeldenummer: 18753158.7
(22) Anmeldetag: 09.08.2018
(51) Int. Cl.: B29C 33/14, B29C 45/14, H01L 21/56, H05K 3/28, B29C 45/57

(54) **VORRICHTUNG UND VERFAHREN ZUR HERSTELLUNG VON MIT EINER GIESSMASSE ZUMINDEST BEREICHSWEISE ÜBERDECKTEN BAUELEMENTEN**
DEVICE AND METHOD FOR PRODUCING COMPONENTS WHICH ARE COVERED WITH A CASTING COMPOUND AT LEAST IN REGIONS
DISPOSITIF ET PROCÉDÉ DE FABRICATION D'ÉLÉMENTS DE CONSTRUCTION RECOUVERTS D'UNE MATIÈRE DE COULÉE AU MOINS PAR ENDROITS

(30) Priorität: 21.09.2017 DE 102017216711
(43) Veröffentlichungstag der Anmeldung: 29.07.2020
(73) Patentinhaber: Robert Bosch GmbH, 70442 Stuttgart (DE)
(72) Erfinder: SCHAAF, Ulrich, 73667 Kaisersbach (DE); KUGLER, Andreas, 73553 Alfdorf (DE)
(86) Internationale Anmeldenummer: PCT/EP2018/071586
(87) Internationale Veröffentlichungsnummer: WO 2019/057388

(56) Entgegenhaltungen:
- WO-A1-2013/066162
- US-A1- 2009 097 139
- US-A1- 2016 368 177

## Beschreibung

### Stand der Technik

Die Erfindung betrifft eine Vorrichtung zur Herstellung von mit einer Gießmasse zumindest bereichsweise überdeckten, auf einem Trägerelement angeordneten Bauelementen nach dem Oberbegriff des Anspruchs 1. Ferner betrifft die Erfindung ein Verfahren unter Verwendung einer erfindungsgemäßen Vorrichtung.

Eine gattungsgemäße Vorrichtung ist aus der DE 10 2014 204 722 A1 der Anmelderin bekannt. Die bekannte Vorrichtung dient dazu, auf einem Trägerelement wie einem Schaltungsträger angeordnete Bauelemente zumindest bereichsweise mit einer Kunststoffmasse, einer sogenannten Moldmasse, zu umgeben. Hierzu weist die bekannte Vorrichtung zwei gegeneinander beweglich angeordnete Werkzeugteile auf, die in einer geschlossenen Position einen Aufnahmeraum für das in dem Aufnahmeraum angeordnete Trägerelement mit den Bauelementen ausbildet (Fig. 14). Zum Ausgleich von Bauteiletoleranzen ist es in der genannten Schrift zusätzlich erwähnt, dass eine Werkzeugoberfläche mit einem PTFE-Film überzogen sein kann. Ein derartiger Film ist stark deformierbar und legt sich formtreu über eine Werkzeugoberfläche an. Zuletzt weist die bekannte Vorrichtung innerhalb des Aufnahmeraums auch eine Erhebung auf, die dazu ausgebildet ist, bei geschlossenen Werkzeugteilen gegen einen nicht von Moldmasse zu überdeckenden Bereich eines Bauelements angelegt zu sein. Dabei kann es sich beispielsweise um eine Membranoberfläche eines Drucksensors handeln. Der aus der genannten Schrift bekannte verformbare Film zum Toleranzausgleich unterliegt während des Betriebs bei der Herstellung der Baugruppen einem gewissen Verschleiß, insbesondere auch deshalb, weil er thermisch durch die mit hohem Druck und hoher Temperatur eingespritzte Moldmasse sowie das beheizbare Werkzeug beansprucht wird. Darüber hinaus ist als nachteilhaft anzusehen, dass je nach verwendetem Material für die Moldmasse bzw. deren Schwindungsverhalten beim Abkühlen gegebenenfalls Spalte oder Freiräume in der Moldmasse entstehen, die die Qualität der mit der Moldmasse überdeckten Struktur negativ beeinflussen können. Weitere gattungsgemäße Vorrichtungen sind aus der US 2016/368177 A1 und aus der US 2009/097139 A1 bekannt.

### Offenbarung der Erfindung

Die erfindungsgemäße Vorrichtung zur Herstellung von mit einer Gießmasse zumindest bereichsweise überdeckten, auf einem Trägerelement angeordneten Bauelementen mit den Merkmalen des Anspruchs 1 hat den Vorteil, dass die Bildung von Hohlräumen bzw. Lufteinschlüssen sowie Spalte beim Erstarren der Gießmasse (Moldmasse) zuverlässig verhindert werden kann. Dadurch ergibt sich eine besonders hohe Qualität von mittels der Vorrichtung ausgebildeten Baugruppen bzw. eine besonders hohe Zuverlässigkeit auch nach langer Betriebsdauer derartiger Baugruppen. Dies wird erfindungsgemäß dadurch erzielt, dass Mittel vorgesehen sind, die dazu ausgebildet sind, in der geschlossenen Stellung der wenigstens zwei Werkzeugteile das Volumen des Aufnahmeraums zu verringern. Mit anderen Worten gesagt bedeutet dies, dass durch die Volumenverringerung des Aufnahmeraums die erstarrende Gießmasse mit Druck beaufschlagt wird, der die Bildung der angesprochenen Hohlräume zuverlässig verhindert. Insbesondere lassen sich damit auch zuverlässig Hohlräume verhindern, die in unmittelbarem Bereich der Bauelemente sich ausbilden können und beim Zutritt von Medien zu einer Vorschädigung oder zu einem Ausfall der Bauelemente führen könnten. Als weiterer Vorteil ist anzusehen, dass durch die Volumenverringerung des Aufnahmeraums beim Erstarren bzw. Aushärten der Gießmasse sichergestellt wird, dass Gießmasse beispielsweise in den Bereich von Hinterschneidungen oder sonstigen, für die Gießmasse schwer zugängliche Bereiche gefördert wird. Dadurch wird auch bei komplexen Formen eine zuverlässige, lückenfreie Umschließung der Bauelemente von dem Material der Gießmasse sichergestellt Vorteilhafte Weiterbildungen der erfindungsgemäßen Vorrichtung sind in den Unteransprüchen aufgeführt.

Wie bereits eingangs erwähnt, kann eine aus flexiblem Material bestehende Beschichtung einer Werkzeugoberfläche mit der Zeit einem Verschleiß aufweisen, der die Funktionalität der Beschichtung negativ beeinflusst. Dies ist desto kritischer, desto höher die Temperaturen der Vorrichtung bzw. des Werkzeugs sowie der Gießmasse sind, und desto mehr Baugruppen mittels der Vorrichtung hergestellt werden. Ein weiterer Aspekt der Erfindung, der den aus dem Stand der Technik potentiell vorhandenen Nachteil vermeidet, sieht daher vor, dass das elastisch ausgebildete Element aus einer an der Gießmasse nicht anhaftenden, flexiblen und vorzugsweise aus Kunststoff bestehenden Bahn besteht, die an einer Werkzeugteiloberfläche anlegbar ist. Durch die Ausbildung des elastischen Elements in Form einer Bahn, die zwar an die Werkzeugteiloberfläche anlegbar ist, jedoch nicht mit dieser beispielsweise stoffschlüssig verbunden ist, wird der Vorteil erzielt, dass ein entsprechender Bahnabschnitt sehr leicht durch einen neuen Bahnabschnitt ersetzt werden kann, sollte sich ein gewisser Verschleiß herausstellen. So kann es durchaus vorgesehen sein, dass zur Optimierung der Qualität der entsprechende Bahnabschnitt nach der Fertigung jeweils einer Baugruppe ersetzt bzw. ausgetauscht wird.

Für diesen Fall ist es in einer besonders bevorzugten Ausgestaltung des zuletzt gemachten Vorschlags vorgesehen, dass die Bahn als endlose Bahn insbesondere in Rollenform bevorratet ausgebildet ist, und dass Fördermittel vorgesehen sind, die dazu ausgebildet sind, in einer Öffnungsstellung der wenigstens zwei Werkzeugteile jeweils einen neuen Bahnabschnitt der endlosen Bahn zwischen die wenigstens zwei Werkzeugteile zu fördern.

Wesentlich für die korrekte Funktion der Bahn ist es, dass sich diese formschlüssig an die entsprechende Werkzeugteiloberfläche anlegt, da durch die Geometrie der Werkzeugteiloberfläche auch die Geometrie bzw. Anordnung der Gießmasse im Bereich der Bauelemente auf dem Trägerelement definiert wird. Hierzu schlägt ein weiterer Aspekt der Erfindung vor, dass erste Unterdruckmittel zum Anlegen der Bahn gegen die Werkzeugteiloberfläche vorgesehen sind. Derartige erste Unterdruckmittel umfassen insbesondere eine Unterdruckquelle, die mit entsprechenden Saugbohrungen in einem Werkzeugteil verbunden ist, wobei die Saugbohrungen in der Werkzeugteiloberfläche auf der der Bahn zugewandten Seite münden, sodass die Bahn über die Saugbohrungen an die Werkzeugteiloberfläche angesaugt wird.

Eine weitere bevorzugte konstruktive Ausgestaltung der Vorrichtung sieht vor, dass die Bahn einem als Unterteil ausgebildeten Werkzeugteil zugeordnet ist, und dass das Unterteil eine wannenförmige Aufnahme zur Begrenzung des Aufnahmeraums und zur Aufnahme der Gießmasse aufweist. Eine derartige konstruktive Ausgestaltung bewirkt, dass die Gießmasse allein durch Schwerkraft bzw. durch entsprechende Dosiervorrichtungen an das Unterteil bzw. den Aufnahmeraum des Unterteils eingebracht werden kann. Es ist somit beispielsweise nicht erforderlich, die Gießmasse mit Druck in den entsprechenden Aufnahmeraum einzuspritzen.

In Weiterbildung des zuletzt gemachten Vorschlags ist es vorgesehen, dass ein als Oberteil ausgebildetes Werkzeugteil vorgesehen ist, und dass zweite Unterdruckmittel vorgesehen sind, die dazu ausgebildet sind, das Trägerelement gegen eine Haltefläche des Oberteils zu halten. Mit anderen Worten gesagt bedeutet dies, dass die Vorrichtung es ermöglicht, das Trägerelement mit den daran an einer Oberfläche befestigten bzw. angeordneten Bauelementen "über Kopf" in die Gießmasse einzutauchen, während das Trägerelement durch die zweiten Unterdruckmittel, die in Analogie zu den ersten Unterdruckmitteln ausgebildet sein können, an dem Oberteil der Vorrichtung gehalten ist. Die zweiten Unterdruckmittel haben insbesondere den Vorteil, dass ein besonders einfaches Handling bzw. eine besonders einfache Positionierung des Trägerelements im Bereich der Vorrichtung ermöglicht wird, die keine zusätzlichen mechanischen, ggf. auf das Trägerelement einwirkende Elemente benötigt.

Wie oben erläutert, besteht der Kerngedanke der Erfindung darin, Mittel vorzusehen, die bei geschlossener Stellung der wenigstens zwei Werkzeugteile das Volumen des Aufnahmeraums verringern, um insbesondere die Schwindung der Gießmasse ausgleichen zu können. In der erfindungsgemäßen Ausgestaltung dieser Mittel umfassen diese wenigstens ein in Richtung des Aufnahmeraums beweglich ausgebildetes Element. Ein derartiges Element kann beispielsweise in Form eines Kolbens, Zylinders oder ähnlichem ausgebildet sein, das in einer entsprechenden Öffnung eines Werkzeugteils geführt bzw. angeordnet ist und mit seiner dem Aufnahmeraum zugewandten Stirnseite bis an die Werkzeugteiloberfläche, die den Aufnahmeraum begrenzt, reicht. Die Bewegung bzw. Kraftbeaufschlagung eines derartigen Elements kann entweder mechanisch, beispielsweise durch einen Stellmotor, pneumatisch oder hydraulisch erfolgen.

In ganz besonders bevorzugter Anordnung des wenigstens einen Elements ist dieses auf der dem Aufnahmeraum abgewandten Seite des elastisch ausgebildeten Elements angeordnet. Dies bewirkt, dass bei einem Eintauchen des Elements in den Aufnahmeraum das elastisch ausgebildete Element entsprechend deformiert wird, wobei insbesondere sichergestellt ist, dass das bewegliche Element nicht in Kontakt mit der Gießmasse gelangen kann. Dadurch wird darüber hinaus die Abdichtung der Führung des Elements in dem Werkzeugteil vereinfacht.

Weiterhin ist es bevorzugt vorgesehen, dass dritte Unterdruckmittel zum Evakuieren des Aufnahmeraums vorgesehen sind. Diese dritten Unterdruckmittel bewirken insbesondere beim bzw. während des Schließens der beiden Werkzeugteile zur Ausbildung des (geschlossenen) Aufnahmeraums, dass im Bereich des Aufnahmeraums befindliche Luft evakuiert wird, sodass anschließend während der Verringerung des Volumens des Aufnahmeraums sich keine Luft mehr in dem Aufnahmeraum befindet, die verdrängt werden muss bzw. zu Lufteinschlüssen in der Gießmasse führen könnte.

Ein weiterer Aspekt der Erfindung betrifft Bauelemente bzw. Bereiche von Bauelementen, die nicht von der Gießmasse überdeckt bzw. abgedeckt werden dürfen, um deren Funktionalität sicherzustellen. Gedacht ist hierbei insbesondere an Membranen von Drucksensoren oder ähnlichen Oberflächen. Hierzu weist wenigstens ein Werkzeugteil eine in den Aufnahmeraum hineinragende Erhöhung auf, die in geschlossener

Stellung der wenigstens zwei Werkzeugteile in Wirkverbindung mit einer nicht von der Gießmasse zu überdeckenden Oberfläche eines Bauelements auf dem Trägerelement positionierbar ist. Mit anderen Worten gesagt bedeutet dies, dass die dem entsprechenden Bauelement zugewandte Stirnseite bzw. Stirnfläche der Erhebung insbesondere in Anlagekontakt mit dem Bauelement angeordnet werden kann, um den Zutritt von Gießmasse an den zu schützenden Bereich des Bauelements zu vermeiden.

Um den Gieß- bzw. Aushärteprozess der Gießmasse verfahrenstechnisch zu optimieren ist es darüber hinaus in vorteilhafter Ausgestaltung der Vorrichtung vorgesehen, dass zumindest das die Gießmasse aufnehmende Werkzeugteil beheizbar ausgebildet ist. Damit werden insbesondere auch Thermospannungen der Gießmasse vermieden bzw. homogenisiert.

Die Erfindung betrifft auch ein Verfahren zur Herstellung von mit einer Gießmasse zumindest bereichsweise überdeckten, auf einem Trägerelement angeordneten Bauelementen mittels einer soweit beschriebenen erfindungsgemäßen Vorrichtung. Das erfindungsgemäße Verfahren umfasst dabei wenigstens folgende Schritte: In einem ersten Schritt wird die Gießmasse in ein Werkzeugteil eingebracht. Weiterhin wird das Trägerelement an einem anderen Werkzeugteil auf der dem Aufnahmeraum zugewandten Seite des anderen Werkzeugteils befestigt. Anschließend erfolgt ein Gegeneinanderbewegen der Werkzeugteile bis in eine geschlossene Stellung, wobei Bauteile auf dem Trägerelement die Gießmasse eintauchen und dabei bereichsweise von der Gießmasse umschlossen werden. Anschließend erfolgt eine Verringerung des Volumens des Aufnahmeraums.

Bevorzugt ist die Verwendung eines Granulats, eines (aufschmelzbaren) Festkörpers in Form eines sogenannten Sheets oder einer Paste für die Gießmasse, wobei die konkrete Wahl des Materials von den jeweiligen Anforderungen abhängt.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: bis
- Fig. 3: eine erste Vorrichtung zum Überdecken von auf einem Trägerelement angeordneten Bauelementen mit einer Gießmasse während unterschiedlicher Stellungen zweier Werkzeugteile der Vorrichtung in vereinfachten Längsschnitten und
- Fig. 4: eine gegenüber den Fig. 1 bis 3 abgewandelte Vorrichtung, ebenfalls im vereinfachten Längsschnitt.

Gleiche Elemente bzw. Elemente mit gleicher Funktion sind in den Figuren mit den gleichen Bezugsziffern versehen.

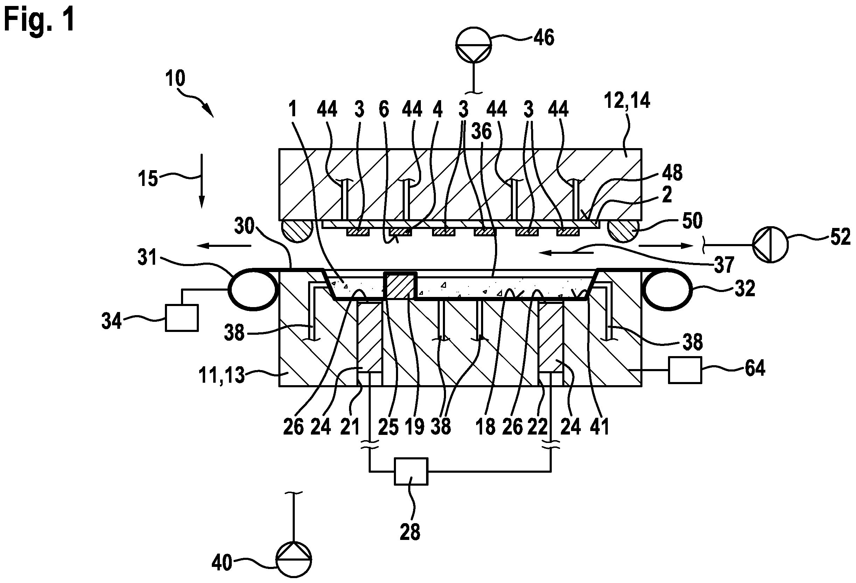

In den Fig. 1 bis 3 ist eine erste Vorrichtung 10 zur Herstellung von mit einer Gießmasse 1 zumindest bereichsweise überdeckten, auf einem Trägerelement 2 angeordneten Bauelementen 3, 4 stark vereinfacht dargestellt. Die aus dem Trägerelement 2 und den Bauelementen 3, 4 bestehende Anordnung trägt insbesondere eine elektronische Schaltung oder ist Teil einer elektronischen Schaltung in einem Steuergerät. Die vorzugsweise zunächst in Form eines Granulats oder einer Paste ausgebildete Gießmasse 1, die auch als Moldmasse bezeichnet wird, dient dem Schutz der auf der einen Seite des Trägerelements 2 angeordneten Bauelementen 3, 4 vor dem Zutritt von funktionsbeeinträchtigenden Medien bzw. Feuchtigkeit. Während die Bauelemente 3 vollständig von der Gießmasse 1 auf dem Trägerelement 2 überdeckt werden sollen, handelt es sich bei dem Bauelement 4 um ein Bauelement 4, das eine Bauteiloberfläche 6 aufweist, die nicht von der Gießmasse 1 überdeckt werden soll. Beispielhaft handelt es sich bei dem Bauelement 4 um einen Drucksensor und bei der Bauteiloberfläche 6 um eine Membran dieses Drucksensors. Die Gießmasse 1 ist beispielsweise in Form eines Granulats oder einer Paste vorgesehen, welche durch Erwärmen verflüssigt werden kann und beim Abkühlen erstarrt bzw. sich verfestigt.

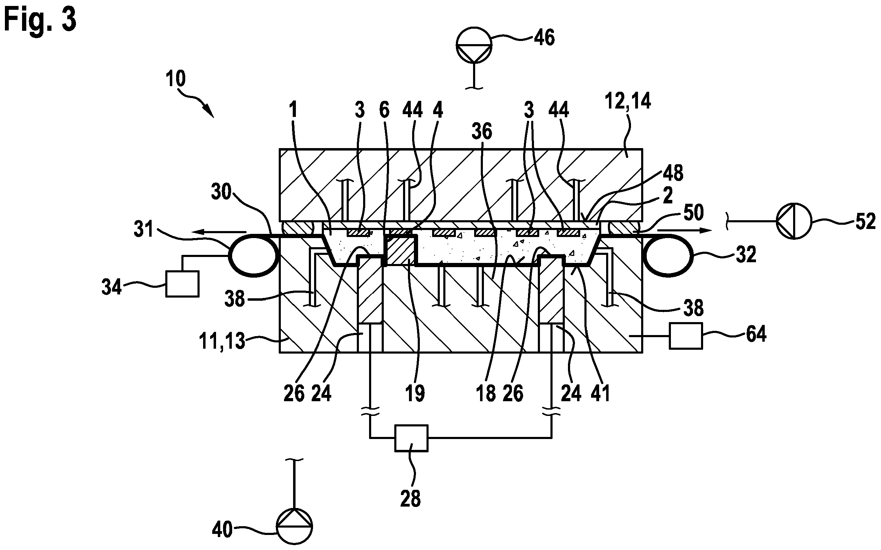

Die Vorrichtung 10 weist im dargestellten Ausführungsbeispiel zwei Werkzeugteile 11, 12 auf, wobei das Werkzeugteil 11 als Unterteil 13 und das Werkzeugteil 12 als Oberteil 14 ausgebildet ist. Die beiden Werkzeugteile 11, 12 sind aus der in der Fig. 1 dargestellten, voneinander beabstandeten Position in eine in der Fig. 3 erkennbare Position zueinander in Richtung des Pfeil 15 beweglich angeordnet. Das Gegeneinanderbewegen der beiden Werkzeugteile 11, 12, die hierzu beispielsweise in entsprechenden Führungen geführt sein können, erfolgt mittels an sich bekannter Mittel, beispielsweise durch motorische Stellantriebe oder hydraulische Mittel, zum Beispiel durch Abwärtsbewegen des Oberteils 14 bei ortsfest angeordnetem Unterteil 13.

Das beispielhaft eine rechteckförmige Grundfläche aufweisende Unterteil 13 weist eine wannenförmige Aufnahme 18 auf, die dazu ausgebildet ist, die Gießmasse 1 aufzunehmen. Weiterhin erhebt sich vom Grund der Aufnahme 18 in Richtung des einen Bauelements 4 eine Erhebung 19, die fluchtend zu der Bauteiloberfläche 6 angeordnet ist, und die in einer geschlossenen Position zueinander positionierten Werkzeugteilen 11, 12 dazu ausgebildet ist, die Bauteiloberfläche 6 zumindest mittelbar abzudecken bzw. zu überdecken, um den Zutritt der Gießmasse 1 an die Bauteiloberfläche 6 zu verhindern.

Das Unterteil 13 weist darüber hinaus mehrere, im Ausführungsbeispiel zylindrisch ausgebildete Durchgangsbohrungen 21, 22 zur Aufnahme von Hubzylindern 24 auf. Aufgrund der Darstellung der Fig. 1 bis 3 sind lediglich zwei Hubzylinder 24 erkennbar. Selbstverständlich kann es je nach Größe des Werkzeugteils 11 bzw. der Aufnahme 18 vorgesehen sein, weniger oder mehr als zwei Hubzylinder 24 mit entsprechenden Durchgangsbohrungen 21, 22 vorzusehen. Auch können unterschiedliche Durchmesser der Hubzylinder 24 vorgesehen sein. Die am Grund 25 der Aufnahme 18 mündenden Durchgangsbohrungen 21, 22 ermöglichen es, die in den Durchgangsbohrungen 21, 22 angeordneten Hubzylinder 24 in die Aufnahme 18 bis über den Grund 25 hinaus einzutauchen, sodass die Hubzylinder 24 mit ihren entsprechenden Stirnseiten 26 in die Aufnahme 18 hineinragen können (Fig. 3). Die Hubzylinder 24 sind mit einem Antrieb 28 gekoppelt, der die Bewegung der Hubzylinder 24 steuert. Der Antrieb 28 kann mechanisch, hydraulisch oder pneumatisch wirkende Mittel aufweisen.

Das Unterteil 13 ist von einem elastisch deformierbaren Element in Form einer endlosen Bahn 30, vorzugsweise aus Kunststoff bestehend, zumindest im Bereich der Aufnahme 18 überspannt. Das Material der Bahn 30 ist derart ausgewählt, dass dieses an dem Material der Gießmasse 1 nicht anhaftet. Ferner ist das Material der (endlosen) Bahn 30 auf zwei Rollen 31, 32 aufgewickelt, die sich beidseitig des Unterteils 13 befinden. Die eine Rolle 31 ist mit einem weiteren Antrieb 34 verbunden, die ein Aufspulen eines innerhalb der Aufnahme 18 befindlichen Bahnabschnitts 36 bei gleichzeitigem Abziehen eines entsprechenden neuen Bahnabschnitts 36 von der anderen Rolle 32 in Richtung des Pfeils 37 ermöglicht (Fig. 1).

Im Bereich der Aufnahme 18 münden eine Vielzahl von Saugbohrungen 38, die beispielhaft mit einer ersten Unterdruckquelle 40 derart verbunden sind, dass bei einem Unterdruck in den Saugbohrungen 38 der im Bereich der Aufnahme 18 befindliche Bahnabschnitt 36 gegen die die Aufnahme 18 bildende Werkzeugteiloberfläche 41 angesaugt wird, wobei sich der Bahnabschnitt 36 formschlüssig an die Kontur der Aufnahme 18 und auch an die Erhebung 19 anlegt, wie dies in der Fig. 1 dargestellt ist.

In dem Werkzeugteil 12 bzw. dem Oberteil 14 sind weitere Saugbohrungen 44 ausgebildet, die beispielhaft mit einer zweiten, gemeinsamen Unterdruckquelle 46 verbunden sind. Die im Bereich einer ebenen Haltefläche 48 des Oberteils 14 mündenden Saugbohrungen 44 dienen dazu, das Trägerelement 2 auf der den Bauelementen 3, 4 abgewandten Seite anzusaugen und gegen die Haltefläche 48 zu halten.

Weiterhin ist auf der dem Unterteil 13 zugewandten Seite des Oberteils 14 wenigstens eine Vakuumdichtung 50 angeordnet, die den Bereich der Aufnahme 18 vollständig umschließt. Diese Vakuumdichtung 50 wirkt mit einer dritten Unterdruckquelle 52 zusammen, die dazu ausgebildet ist, bei einer Betätigung den Bereich der Aufnahme 18 bei gegeneinander bewegten Werkzeugteilen 11, 12 zu evakuieren.

Die Funktionsweise der soweit beschriebenen Vorrichtung 10 wird anhand der Figurenfolge der Fig. 1 bis 3 wie folgt erläutert: In der Fig. 1 ist ein Bahnabschnitt 38 im Bereich der Aufnahme 18 angeordnet, der sich an die Werkzeugteiloberfläche 41 angelegt hat, was durch eine entsprechende Betätigung der ersten Unterdruckquelle 40 verursacht wurde. Weiterhin befindet sich im Bereich der Aufnahme 18 die zum Überdecken der Bauelemente 3, 4 vorgesehene Menge an Gießmasse 1. Diese Gießmasse 1 wurde vorab bei den voneinander beabstandeten Werkzeugteilen 11, 12 durch eine nicht dargestellte Dosiereinrichtung in die Aufnahme 18 eingebracht. Weiterhin erkennt man anhand der Fig. 1, in der sich die beiden Werkzeugteile 11, 12 noch in einer beabstandeten Position voneinander befinden, dass das Trägerelement 2 mit den Bauelementen 3, 4 mittels der zweiten Unterdruckquelle 46 an der Haltefläche 48 des Oberteils 14 positioniert ist.

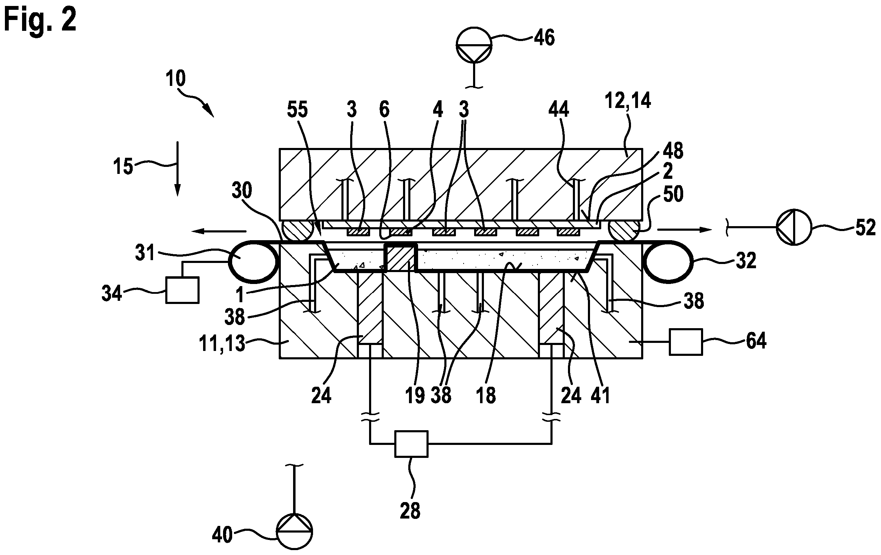

Anschließend werden entsprechend der Fig. 2 das Unterteil 13 und das Oberteil 14 der Vorrichtung 10 gegeneinander bewegt, sodass die Vakuumdichtung 50 an der Bahn 30 bzw. dem Unterteil 13 anliegt. Gleichzeitig wird mittels der dritten Unterdruckquelle 52 durch die Vakuumdichtung 50 hindurch der sich zwischen dem Unterteil 13 und dem Oberteil 14 ausbildende Aufnahmeraum 55 evakuiert.

In der Fig. 3 ist der Zustand dargestellt, bei der die beiden Werkzeugteile 11, 12 ihre geschlossene Endposition zueinander eingenommen haben. In dieser Position liegt die Erhebung 19 unter Zwischenlage des Bahnabschnitts 38 an der Bauteiloberfläche 6 des Bauelements 4 an. Weiterhin ist erkennbar, dass die beiden Hubzylinder 24 nach dem Evakuieren des Aufnahmeraums 55 in den Aufnahmeraum 55 etwas eingetaucht sind. Dadurch wurde das ursprüngliche Volumen des Aufnahmeraums 55 verringert, um die Schwindung der Gießmasse 1 bei deren Aushärtung auszugleichen und sicherzustellen, dass Gießmasse 1 in allen dafür vorgesehenen Bereichen, also auch in den Bereich von evtl. vorhandenen Hinterschnitten oder ähnlichem im Bereich der Bauelemente 3, 4 bzw. des Trägerelements 2 gelangt. Die in der Fig. 3 dargestellte Stellung der beiden Werkzeugteile 11, 12 wird solange beibehalten, bis eine genügend starke Aushärtung der Gießmasse 1 stattgefunden hat, die beim anschließenden Wiederöffnen der Vorrichtung 10 eine Entnahme der Bauteile samt Gießmasse 1 von dem Oberteil 14 ermöglichen.

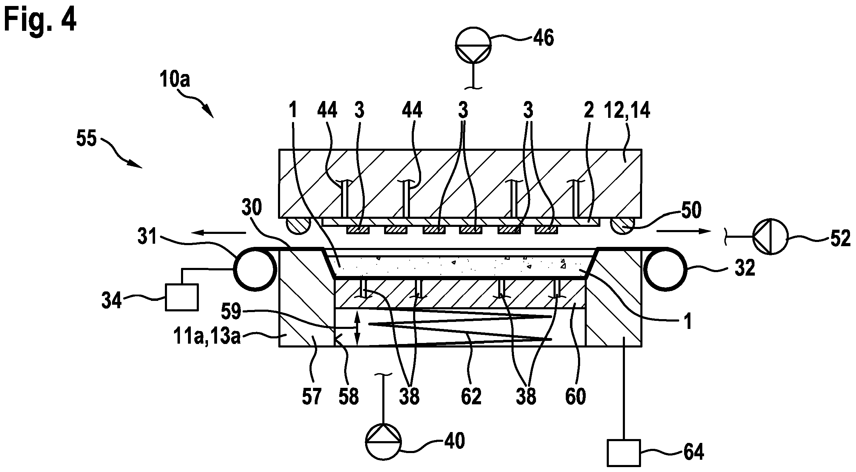

In der Fig. 4 ist eine gegenüber den Fig. 1 bis 3 abgewandelte Vorrichtung 10a dargestellt. Die Vorrichtung 10a unterscheidet sich von der Vorrichtung 10 zum einen dadurch, dass im Bereich des Unterteils 13a keine Erhebung 19 vorgesehen ist. Weiterhin ist das Werkzeugteil 11a bzw. das Unterteil 13a mehrteilig ausgebildet, mit einem (starren) Rahmen 57, der eine Ausnehmung 58 aufweist, innerhalb derer eine in Richtung des Doppelpfeils 59 beweglich angeordneter Boden 60 angeordnet ist. Der Boden 60 ist beispielhaft mit einem Federelement 62 kraftbeaufschlagt, sodass entsprechend der Hubzylinder 24 bei der Vorrichtung 10 bei geschlossener Vorrichtung 10a durch den Boden 60 auf die Gießmasse 1 ein Druck ausübbar ist, der das Volumen des Aufnahmeraums 55 verringert.

Die soweit beschriebene Vorrichtung 10, 10a kann in vielfältiger Art und Weise abgewandelt bzw. modifiziert werden, ohne vom Erfindungsgedanken abzuweichen. So eignet sich die Vorrichtung 10, 10a insbesondere auch dazu, großflächig ausgebildete Trägerelemente 2 mit einer Vielzahl entsprechender Bauelemente 3, 4 mit der Gießmasse 1 zu überdecken, wonach anschließend das Trägerelement 2 in eine Vielzahl von Baugruppen vereinzelt werden kann, die jeweils vorzugsweise identische Schaltungen für Steuergeräte oder ähnliches ausbilden. Weiterhin kann es vorgesehen sein, dass auf die Hubzylinder 24 verzichtet wird, und eine Verringerung des Volumens des Aufnahmeraums 55 durch insbesondere pneumatische Druckbeaufschlagung der Durchgangsbohrungen 21, 22 erfolgt. Zuletzt kann es insbesondere auch vorgesehen sein, dass die Vorrichtung 10, 10a zumindest im Bereich des Unterteils 13, 13a eine Heizeinrichtung 64 aufweist.

## Patentansprüche

1. Vorrichtung (10; 10a) zur Herstellung von mit einer Gießmasse (1) zumindest bereichsweise überdeckten, auf einem Trägerelement (2) angeordneten Bauelementen (3, 4), mit wenigstens zwei zueinander beweglich angeordneten Werkzeugteilen (11; 11a, 12), die in einer geschlossenen Stellung einen Aufnahmeraum (55) zur Aufnahme des Trägerelements (2) mit den Bauelementen (3, 4) und der Gießmasse (1) ausbilden, wobei wenigstens ein erstes Werkzeugteil (11; 11a) auf der diesem Werkzeugteil (11; 11a) zugewandten Seite in Wirkverbindung mit einem elastisch ausgebildeten Element (30) angeordnet ist,
wobei das erste Werkzeugteil Mittel (24) aufweist, die dazu ausgebildet sind, in der geschlossenen Stellung der wenigstens zwei Werkzeugteile (11; 11a, 20, 12) das Volumen des Aufnahmeraums (55) zu verringern,
wobei die Mittel (24) wenigstens ein in Richtung des Aufnahmeraums (55) beweglich ausgebildetes Element des ersten Werkzeugteils (11) aufweisen,
**dadurch gekennzeichnet**
**dass** das erste Werkzeugteil (11) eine in den Aufnahmeraum (55) hineinragende Erhebung (19) aufweist, die in geschlossener Stellung der wenigstens zwei Werkzeugteile (11, 12) in Wirkverbindung mit einer nicht von Gießmasse (1) zu überdeckenden Oberfläche (6) eines Bauelements (4) auf dem Trägerelement (2) positionierbar ist,
und **dass** die Erhebung (19) nicht auf den Mitteln (24) positioniert ist.

2. Vorrichtung nach Anspruch 1,
**dadurch gekennzeichnet,**
**dass** das elastisch ausgebildete Element (30) aus einer an der Gießmasse (1) nicht anhaftenden, flexiblem und vorzugsweise aus Kunststoff bestehenden Bahn besteht, die an eine Werkzeugteiloberfläche (41) eines Werkzeugteils (11; 11a) formschlüssig anlegbar ist.

3. Vorrichtung nach Anspruch 2,
**dadurch gekennzeichnet,**
**dass** die Bahn als endlose Bahn insbesondere in Rollenform bevorratet ausgebildet ist, und dass Fördermittel (34) vorgesehen sind, die dazu ausgebildet sind, in einer Öffnungsstellung der wenigstens zwei Werkzeugteile (11; 11a, 12) einen Bahnabschnitt (36) der endlosen Bahn zwischen die wenigstens zwei Werkzeugteile (11; 11a, 12) zu fördern.

4. Vorrichtung nach Anspruch 2 oder 3,
**dadurch gekennzeichnet,**
**dass** erste Unterdruckmittel (38, 40) zum Anlegen der Bahn gegen die Werkzeugteiloberfläche (41) vorgesehen sind.

5. Vorrichtung nach einem der Ansprüche 2 bis 4,
**dadurch gekennzeichnet,**
**dass** die Bahn einem als Unterteil (13; 13a) ausgebildeten Werkzeugteil (11; 11a) zugeordnet ist, und dass das Unterteil (13; 13a) eine wannenförmige Aufnahme (18) zur Begrenzung des Aufnahmeraums (55) und zur Aufnahme der Gießmasse (1) aufweist.

6. Vorrichtung nach Anspruch 5,
**dadurch gekennzeichnet,**
**dass** ein als Oberteil (14) ausgebildetes Werkzeugteil (12) vorgesehen ist, und dass zweite Unterdruckmittel (44, 46) vorgesehen sind, die dazu ausgebildet sind, das Trägerelement (2) auf der dem Werkzeugteil (12) zugewandten Seite mit der den Bauelementen (3, 4) abgewandten Seite des Trägerelements (2) gegen eine Haltefläche (48) des Oberteils (14) zu halten.

7. Vorrichtung nach einem der Ansprüche 1 bis 6,
**dadurch gekennzeichnet,**
**dass** das wenigstens eine beweglich ausgebildete Element durch mechanisch, pneumatisch oder hydraulisch wirkende Mittel (28; 62) in Richtung des Aufnahmeraums (55) kraftbeaufschlagbar ist.

8. Vorrichtung nach einem der Ansprüche 1 bis 7,
**dadurch gekennzeichnet,**
**dass** das wenigstens eine Element auf der dem Aufnahmeraum (55) abgewandten Seite des elastisch ausgebildeten Elements (30) angeordnet ist.

9. Vorrichtung nach einem der Ansprüche 1 bis 8,
**dadurch gekennzeichnet,**
**dass** dritte Unterdruckmittel (50, 52) zum Evakuieren des Aufnahmeraums (55) vorgesehen sind.

10. Vorrichtung nach einem der Ansprüche 1 bis 9,
**dadurch gekennzeichnet,**
**dass** zumindest das die Gießmasse (1) aufnehmende Werkzeugteil (11; 11a) beheizbar ausgebildet ist.

11. Verfahren zur Herstellung von mit einer Gießmasse (1) zumindest bereichsweise überdeckten, auf einem Trägerelement (2) angeordneten Bauelementen (3, 4) mittels einer Vorrichtung (10; 10a), die nach einem der Ansprüche 1 bis 10 ausgebildet ist, umfassend zumindest folgende Schritte:
- Einbringen von Gießmasse (1) in ein Werkzeugteil (11; 11a)
- Befestigen des Trägerelements (2) an einem anderen Werkzeugteil (12) derart, dass die Bauelemente (3, 4) in Richtung zum Werkzeugteil (11; 11a) ragen
- Gegeneinanderbewegen der Werkzeugteile (11; 11a, 12) bis in eine geschlossene Stellung, wobei Bauelemente (3, 4) auf dem Trägerelement (2) in die Gießmasse (1) eintauchen und dabei zumindest bereichsweise von der Gießmasse (1) umschlossen werden
- Verringerung des Volumens des Aufnahmeraums (55), das das Trägerelement (2), die Bauelemente (3, 4) und die Gießmasse (1) umgibt

12. Verfahren nach Anspruch 11,
**dadurch gekennzeichnet,**
**dass** der Aufnahmeraum (55) vor dem Verringern des Volumens evakuiert wird.

13. Verfahren nach Anspruch 11 oder 12,
**dadurch gekennzeichnet,**
**dass** als Gießmasse (1) ein Granulat, ein Festkörper oder eine Paste verwendet wird.

## Claims

1. Device (10; 10a) for producing components (3, 4) which are arranged on a carrier element (2) and are covered, at least in certain regions, with a casting compound (1), said device having at least two die parts (11; 11a, 12), which are arranged so as to be movable in relation to one another and which, in a closed position, form a receiving space (55) for receiving the carrier element (2) with the components (3, 4) and the casting compound (1), wherein at least a first die part (11; 11a), on the side facing said die part (11; 11a), is arranged in operative connection with an element (30) formed as elastic,
wherein the first die part has means (24) which are designed to reduce the volume of the receiving space (55) in the closed position of the at least two die parts (11; 11a, 20, 12), wherein the means (24) comprise at least one element of the first die part (11) that is designed to be movable in the direction of the receiving space (55),
**characterized in that** the first die part (11) has a raised portion (19), which projects into the receiving space (55) and, in the closed position of the at least two die parts (11, 12), can be positioned in operative connection with a surface (6) of a component (4) on the carrier element (2) that is not to be covered with casting compound (1),
and **in that** the raised portion (19) is not positioned on the means (24).

2. Device according to Claim 1,
**characterized in that** the element (30) formed as elastic consists of a flexible web which does not adhere to the casting compound (1), preferably consists of plastic, and can be placed in form-fitting engagement on a die part surface (41) of a die part (11; 11a).

3. Device according to Claim 2,
**characterized in that** the web is in the form of an endless web, in particular stored in roll form, and **in that** conveying means (34) designed to convey a web portion (36) of the endless web between the at least two die parts (11; 11a, 12) in an open position of the at least two die parts (11; 11a, 12) are provided.

4. Device according to Claim 2 or 3,
**characterized in that** first vacuum means (38, 40) for placing the web against the die part surface (41) are provided.

5. Device according to one of Claims 2 to 4,
**characterized in that** the web is assigned to a die part (11; 11a) in the form of a bottom part (13; 13a), and **in that** the bottom part (13; 13a) has a trough-shaped receptacle (18) for delimiting the receiving space (55) and for receiving the casting compound (1).

6. Device according to Claim 5,
**characterized in that** a die part (12) in the form of a top part (14) is provided, and **in that** second vacuum means (44, 46) designed to hold the carrier element (2) against a holding surface (48) of the top part (14) on the side facing the die part (12) by means of that side of the carrier element (2) that faces away from the components (3, 4) are provided.

7. Device according to one of Claims 1 to 6,
**characterized in that** the at least one movably designed element can be subjected to an application of pressure in the direction of the receiving space (55) by mechanically, pneumatically or hydraulically acting means (28; 62).

8. Device according to one of Claims 1 to 7,
**characterized in that** the at least one element is arranged on that side of the element (30) formed as elastic that faces away from the receiving space (55).

9. Device according to one of Claims 1 to 8,
**characterized in that** third vacuum means (50, 52) for evacuating the receiving space (55) are provided.

10. Device according to one of Claims 1 to 9,
**characterized in that** at least the die part (11; 11a) that receives the casting compound (1) has a heatable design.

11. Method for producing components (3, 4) arranged on a carrier element (2) and covered, at least in certain regions, with a casting compound (1), said method being carried out by means of a device (10; 10a) designed according to one of Claims 1 to 10, said method comprising at least the following steps:
- introducing casting compound (1) into one die part (11; 11a),
- securing the carrier element (2) to another die part (12) in such a way that the components (3, 4) project in the direction of the die part (11; 11a),
- moving the die parts (11; 11a, 12) towards one another into a closed position, wherein components (3, 4) on the carrier element (2) dip into the casting compound (1) and, in the process, are enclosed, at least in certain regions, by the casting compound (1),
- reducing the volume of the receiving space (55) which surrounds the carrier element (2), the components (3, 4) and the casting compound (1).

12. Method according to Claim 11,
**characterized in that** the receiving space (55) is evacuated before reducing the volume.

13. Method according to Claim 11 or 12,
**characterized in that** a granular material, a solid or a paste is used as casting compound (1).

## Revendications

1. Dispositif (10 ; 10a) pour la fabrication d'éléments de construction (3, 4) recouverts au moins par zones d'une matière de coulée (1), agencés sur un élément de support (2), avec au moins deux parties d'outil (11 ; 11a, 12) agencées de manière mobile l'une par rapport à l'autre qui, dans une position fermée, forment un espace de réception (55) pour recevoir l'élément de support (2) avec les éléments de construction (3, 4) et la matière de coulée (1), au moins une première partie d'outil (11 ; 11a) étant agencée sur le côté tourné vers cette partie d'outil (11 ; 11a) en liaison active avec un élément (30) configuré sous forme élastique,
la première partie d'outil présentant des moyens (24) qui sont configurés pour réduire le volume de l'espace de réception (55) dans la position fermée des au moins deux parties d'outil (11 ; 11a, 20, 12),
les moyens (24) présentant au moins un élément de la première partie d'outil (11) configuré sous forme mobile en direction de l'espace de réception (55),
**caractérisé en ce que**
la première partie d'outil (11) présente un relief (19) qui fait saillie dans l'espace de réception (55), qui, en position fermée des au moins deux parties d'outil (11, 12), peut être positionné sur l'élément de support (2) en liaison active avec une surface (6) d'un élément de construction (4) qui ne doit pas être recouverte par la matière de coulée (1),
et **en ce que** le relief (19) n'est pas positionné sur les moyens (24).

2. Dispositif selon la revendication 1, **caractérisé en ce que** l'élément configuré sous forme élastique (30) est constitué d'une bande flexible et de préférence constituée de matière plastique, qui n'adhère pas à la matière de coulée (1), qui peut être appliquée par complémentarité de forme contre une surface de partie d'outil (41) d'une partie d'outil (11 ; 11a).

3. Dispositif selon la revendication 2, **caractérisé en ce que** la bande est configurée sous forme de bande sans fin, notamment stockée sous forme de rouleau, et en ce des moyens de transport (34) sont prévus, qui sont configurés pour, dans une position d'ouverture des au moins deux parties d'outil (11 ; 11a, 12), transporter une section de bande (36) de la bande sans fin entre les au moins deux parties d'outil (11 ; 11a, 12).

4. Dispositif selon la revendication 2 ou 3, **caractérisé en ce que** des premiers moyens de dépression (38, 40) sont prévus pour appliquer la bande contre la surface de partie d'outil (41).

5. Dispositif selon l'une quelconque des revendications 2 à 4, **caractérisé en ce que** la bande est associée à une partie d'outil (11 ; 11a) configurée sous forme de partie inférieure (13 ; 13a), et **en ce que** la partie inférieure (13 ; 13a) présente un logement (18) en forme de cuvette pour délimiter l'espace de réception (55) et pour recevoir la matière de coulée (1).

6. Dispositif selon la revendication 5, **caractérisé en ce qu'**une partie d'outil (12) configurée sous forme de partie supérieure (14) est prévue, et **en ce que** des deuxièmes moyens de dépression (44, 46) sont prévus, qui sont configurés pour maintenir l'élément de support (2) sur le côté tourné vers la partie d'outil (12) avec le côté de l'élément de support (2) détourné des éléments de construction (3, 4) contre une surface de maintien (48) de la partie supérieure (14).

7. Dispositif selon l'une quelconque des revendications 1 à 6, **caractérisé en ce que** l'au moins un élément configuré sous forme mobile peut être sollicité par une force en direction de l'espace de réception (55) par des moyens (28 ; 62) à action mécanique, pneumatique ou hydraulique.

8. Dispositif selon l'une quelconque des revendications 1 à 7, **caractérisé en ce que** l'au moins un élément est agencé sur le côté de l'élément (30) configuré sous forme élastique qui est détourné de l'espace de réception (55).

9. Dispositif selon l'une quelconque des revendications 1 à 8, **caractérisé en ce que** des troisièmes moyens de dépression (50, 52) sont prévus pour faire le vide dans l'espace de réception (55).

10. Dispositif selon l'une quelconque des revendications 1 à 9, **caractérisé en ce qu'**au moins la partie d'outil (11 ; 11a) recevant la matière de coulée (1) est configurée pour pouvoir être chauffée.

11. Procédé de fabrication d'éléments de construction (3, 4) recouverts au moins par zones d'une matière de coulée (1), agencés sur un élément de support (2), au moyen d'un dispositif (10 ; 10a) qui est configuré selon l'une quelconque des revendications 1 à 10, comprenant au moins les étapes suivantes :
- l'introduction de matière de coulée (1) dans une partie d'outil (11 ; 11a) ;
- la fixation de l'élément de support (2) à une autre partie d'outil (12) de telle sorte que les éléments de construction (3, 4) font saillie en direction de la partie d'outil (11 ; 11a) ;
- le déplacement des parties d'outil (11 ; 11a, 12) l'une vers l'autre jusqu'à une position fermée, les éléments de construction (3, 4) sur l'élément de support (2) plongeant dans la matière de coulée (1) et étant alors enrobés au moins par zones par la matière de coulée (1) ;
- la réduction du volume de l'espace de réception (55) qui entoure l'élément de support (2), les éléments de construction (3, 4) et la matière de coulée (1).

12. Procédé selon la revendication 11, **caractérisé en ce que** l'espace de réception (55) est mis sous vide avant la réduction de volume.

13. Procédé selon la revendication 11 ou 12, **caractérisé en ce qu'**un granulat, un corps solide ou une pâte est utilisé en tant que matière de coulée (1).
